# FASCICULE DE BREVET EUROPEEN

(11) **EP 1 100 750 B1**
(45) Date de publication et mention de la délivrance du brevet: **01.10.2003**
(21) Numéro de dépôt: 99929500.9
(22) Date de dépôt: 19.07.1999
(51) Int. Cl.: C01B 33/113, H01L 21/316

(54) **PROCEDE DE FORMATION D'UNE COUCHE D'OXYDE D'EPAISSEUR NON-UNIFORME A LA SURFACE D'UN SUBSTRAT DE SILICIUM**
HERSTELLUNG EINER OXIDSCHICHT MIT NICHT GLEICHMÄSSIGER DICKE AUF DER OBERFLÄCHE EINES SILIZIUMSUBSTRATS
METHOD FOR FORMING AN OXIDE FILM WITH NON-UNIFORM THICKNESS AT A SILICON SUBSTRATE SURFACE

(30) Priorité: 28.07.1998 FR 9809607
(43) Date de publication de la demande: 23.05.2001
(73) Titulaire: FRANCE TELECOM exploitant public, 75015 Paris (FR)
(72) Inventeur: HALIMAOUI, Aomar, F-38100 Grenoble (FR); GROUILLET, André, F-38000 Grenoble (FR)
(74) Mandataire: Casalonga, Axel
(86) Numéro de dépôt international: FR9901756
(87) Numéro de publication internationale: WO00006489

(56) Documents cités:
- WO-A-97/41593
- US-A- 5 021 354
- US-A- 5 106 768
- PATENT ABSTRACTS OF JAPAN vol. 010, no. 164 (E-410), 11 juin 1986 (1986-06-11) & JP 61 016530 A (MATSUSHITA DENSHI KOGYO KK), 24 janvier 1986 (1986-01-24)

## Description

La présente invention concerne de manière générale un procédé pour former une couche d'oxyde de silicium et plus particulièrement une couche d'oxyde de silicium d'épaisseur non-uniforme à la surface d'un substrat de silicium.

En microélectronique, la couche d'oxyde de grille qui est un élément fondamental de nombreux dispositifs semi-conducteurs tels que les transistors MOS, est de plus en plus mince. Aussi, dans la technologie 0,18 µm, on prévoit des épaisseurs inférieures à 4 nm pour la couche d'oxyde de grille. Cette diminution de l'épaisseur de la couche d'oxyde de grille conduit nécessairement à réduire les tensions d'alimentation des dispositifs afin d'éviter une dégradation prématurée de la couche d'oxyde de grille. Dans le cas des microprocesseurs, il n'est pas toujours possible de réduire la tension d'alimentation, à cause des bus d'entrée/sortie (bus E/S) qui nécessitent des tensions plus élevées. Pour résoudre ce problème, on a fait croître, sur des zones déterminées d'un même substrat de silicium, des couches d'oxyde de silicium d'épaisseurs différentes, les couches d'oxyde les plus épaisses étant formées là où les tensions appliquées seront les plus élevées.

Pour obtenir, sur une surface d'un même substrat de silicium, une couche d'oxyde de silicium présentant deux épaisseurs différentes dans des zones prédéterminées de la surface du substrat, on a utilisé un procédé d'oxydation en deux étapes.

La première étape du procédé consistait à faire croître par oxydation une première couche d'oxyde de silicium d'épaisseur uniforme sur la surface du substrat.

La deuxième étape consistait à faire croître par oxydation une deuxième couche d'oxyde de silicium, mais avec un masquage de zones prédéterminées de la surface du substrat déjà recouverte de la première couche d'oxyde pour ainsi obtenir une couche finale d'oxyde de plus grande épaisseur dans les zones non masquées.

L'inconvénient majeur de ce procédé est la contamination de l'oxyde de grille pendant les étapes de masquage et de gravure.

Pour remédier aux inconvénients du procédé de masquage précédent, on a récemment proposé un procédé de croissance d'une couche d'oxyde d'épaisseur non uniforme en une seule étape. Ce procédé consiste à former à la surface du substrat, des zones prédéterminées ayant une cinétique d'oxydation ralentie par implantation ionique d'azote dans ces zones prédéterminées, là où l'on souhaite obtenir une couche d'oxyde plus mince, puis à faire croître une couche d'oxyde de silicium par oxydation de la surface du substrat de silicium. Un tel procédé est décrit entre autres dans l'article "Formation of Ultrathin Nitrided SiO₂ Oxides by direct Nitrogen Implantation into Silicon (Formation d'Oxydes SiO₂ nitrurés ultraminces par implantation directe d'azote dans du silicium)", H.R. Soleimani, B.S. Doyle et A. Philipossian - J. Elechtrochem. Soc., Vol. 142, N°8, août 1998.

Ce dernier procédé présente également de graves inconvénients. En effet, la forte dose d'azote implanté (>10¹⁵ cm⁻²) conduit inévitablement à la dégradation de la couche mince d'oxyde de grille. Cet inconvénient est d'autant plus gênant que les zones implantées sont majoritaires sur le substrat et que la couche d'oxyde y est plus mince (donc plus sensible aux problèmes de dégradation).

La présente invention a donc pour objet un procédé pour faire croître sur une surface d'un substrat de silicium une couche d'oxyde de silicium d'épaisseur non-uniforme et remédiant aux inconvénients des procédés de l'art antérieur.

Tel qu'il est revendiqué, le procédé a pour objet de former sur une surface d'un substrat de silicium cristallin une couche d'oxyde de grille d'épaisseur non-uniforme.
Selon l'invention, le procédé comprend :
a) l'implantation dans des zones prédéterminées du substrat de silicium cristallin d'une dose effective d'atomes d'une espèce chimique accélérant la cinétique d'oxydation du substrat et ne modifiant pas les propriétés électriques du substrat et choisie parmi Si, Ge, Ar, Ne et He ; et
b) la croissance par oxydation d'une couche d'oxyde de grille d'épaisseur non-uniforme sur la surface du substrat de silicium cristallin.

Les espèces implantables préférées accélérant la cinétique d'oxydation d'un substrat de silicium sont, Ne et He et mieux Ar.

Bien que l'implantation de phosphore ou d'arsenic accélère la cinétique d'oxydation d'un substrat de silicium, ces espèces présentent toutefois l'inconvénient d'être des dopants du silicium qui modifient ses propriétés électriques, ce qui n'est pas toujours souhaitable.

L'accélération de la cinétique d'oxydation d'un substrat de silicium dépend bien évidemment de la nature de l'espèce chimique implantée, de la dose implantée et de l'énergie d'implantation. En général, la dose d'espèce chimique implantée variera entre 5.10¹³ et 5.10¹⁵ atomes. cm⁻², de préférence de 1.10¹⁵ à 5.10¹⁵ atomes.cm⁻².

L'énergie d'implantation peut varier de moins de 2 keV à plus de 100 keV, mais est généralement de 2 à 80 keV, de préférence de 2 à 15 keV.

L'implantation d'atomes d'une espèce chimique dans un substrat de silicium est classique et bien connue dans la technique. Ainsi, on peut utiliser un procédé et un appareillage d'implantation ionique classique où l'espèce chimique à implanter est ionisée avant d'être accélérée au moyen d'un champ électrique.

Un appareillage classique pour effectuer une telle implantation est l'appareil VARIAN de type SHC 80.

Le procédé de l'invention est utilisé avec un substrat de silicium cristallin.

L'étape de croissance de la couche d'oxyde de silicium est classique et peut être effectuée par oxydation dans un four standard à une température supérieure à 300°C et sous une atmosphère oxydante, telle que oxygène, oxygène dilué, vapeur d'eau, ozone ou autres. On peut également utiliser d'autres procédés d'oxydation classiques tels que l'oxydation sous plasma, l'oxydation électrochimique, l'oxydation thermique rapide (RTO).

### EXEMPLE

On a fait croître sur des plaquettes de silicium une couche d'oxyde de silicium par oxydation thermique dans un four standard (de marque SVG) à une température de 900°C pendant 6 minutes, sous atmosphère d'oxygène.

Certaines des plaquettes ont été préalablement soumises à une implantation ionique d'argon de manière semblable mais avec des énergies d'implantation différentes (Appareil d'implantation VARIAN SHC 80).

On a mesuré par ellipsométrie l'épaisseur des couches d'oxyde de silicium obtenues. Les résultats sont donnés dans le tableau I ci-dessous.

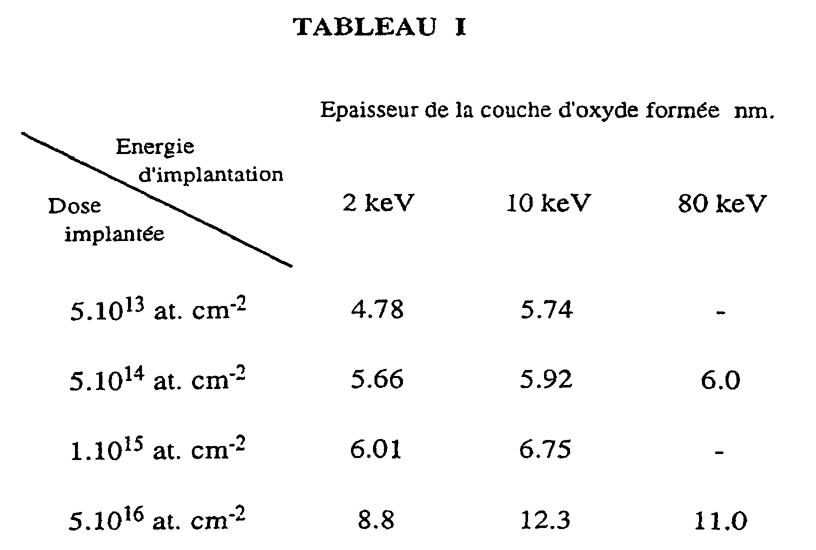

A titre comparatif, l'épaisseur de la couche d'oxyde obtenue dans les mêmes conditions d'oxydation sur une plaquette de silicium semblable n'ayant pas subi d'oxydation est de 4,7 nm.

L'implantation de Ne ou He conduit aux mêmes résultats que l'argon.

Du fait que le procédé selon l'invention est basé sur l'accroissement de la cinétique d'oxydation d'un substrat de silicium et non sur un ralentissement de cette cinétique, ce qui est le cas de l'art antérieur, on élimine le risque de dégradation des zones dans lesquelles la couche d'oxyde est la plus mince tout en obtenant des couches d'oxyde d'épaisseurs accrues adaptées pour supporter des tensions plus élevées, par exemple au niveau des bus E/S.

## Revendications

1. Procédé pour former sur une surface d'un substrat de silicium cristallin une couche d'oxyde de grille d'épaisseur non-uniforme, **caractérisé en ce qu'**il comprend :
a) l'implantation dans des zones prédéterminées du substrat de silicium cristallin d'une dose effective d'atomes d'une espèce chimique accélérant la cinétique d'oxydation du substrat et ne modifiant pas les propriétés électriques du substrat et choisie parmi Si, Ge, Ar, Ne et He ; et
b) la croissance par oxydation d'une couche d'oxyde de grille d'épaisseur non-uniforme sur la surface du substrat de silicium cristallin.

2. Procédé selon la revendication 1, **caractérisé en ce que** l'espèce chimique est choisie parmi Ne et He.

3. Procédé selon la revendication 1, **caractérisé en ce que** l'espèce chimique est Ar.

4. Procédé selon l'une quelconque des revendications 1 à 3, **caractérisé en ce que** l'énergie d'implantation est comprise entre 2 et 100 keV, de préférence 2 à 15 keV.

5. Procédé selon l'une quelconque des revendications 1 à 4, **caractérisé en ce que** la dose implantée est de 5.10¹³ à 5.10¹⁵ atomes.cm⁻², de préférence 1.10¹⁵ à 5.10¹⁵ atomes.cm⁻².

6. Procédé selon l'une quelconque des revendications 1 à 5, **caractérisé en ce que** l'étape d'implantation est une étape d'implantation ionique.

7. Procédé selon l'une quelconque des revendications 1 à 6, **caractérisé en ce que** l'étape de croissance par oxydation est une étape d'oxydation dans un four, d'oxydation par plasma, d'oxydation électrochimique ou d'oxydation thermique rapide.

8. Procédé selon la revendication 7, **caractérisé en ce que** l'étape de croissance de la couche d'oxyde de grille est une étape d'oxydation dans un four à une température d'au moins 300°C et sous atmosphère oxydante.

## Claims

1. Process for forming a gate oxide layer of non-uniform thickness on a surface of a crystalline silicon substrate, **characterized in that** it comprises:
a) the implantation in predetermined regions of the crystalline silicon substrate of an effective dose of atoms of a chemical species which increases the rate of oxidation of the substrate and which does not modify the electrical properties of the substrate, and which is chosen from Si, Ge, Ar, Ne and He; and
b) the growth of a gate oxide layer of non-uniform thickness by oxidation on the surface of the crystalline silicon substrate.

2. Process according to Claim 1, **characterized in that** the chemical species is chosen from Ne and He.

3. Process according to Claim 1, **characterized in that** the chemical species is Ar.

4. Process according to any one of Claims 1 to 3, **characterized in that** the implantation energy is between 2 and 100 keV, preferably 2 to 15 keV.

5. Process according to any one of Claims 1 to 4, **characterized in that** the implanted dose is from 5 x 10¹³ to 5 x 10¹⁵ atoms/cm², preferably 1 x 10¹⁵ to 5 x 10¹⁵ atoms/cm².

6. Process according to any one of Claims 1 to 5, **characterized in that** the implantation step is an ion implantation step.

7. Process according to any one of Claims 1 to 6, **characterized in that** the growth step by oxidation is an oxidation step in a furnace, by plasma oxidation, electrochemical oxidation or rapid thermal oxidation.

8. Process according to Claim 7, **characterized in that** the step of growing the gate oxide layer is an oxidation step in a furnace at a temperature of at least 300°C and in an oxidizing atmosphere.

## Patentansprüche

1. Verfahren zum Bilden einer Gitteroxidschicht mit ungleichmäßiger Stärke auf einer Oberfläche eines Substrats aus kristallinem Silizium, **dadurch gekennzeichnet, dass** es folgendes umfasst:
a) die Implantation einer effektiven Dosis Atome einer chemischen Gattung in vorausbestimmten Zonen des Substrats aus kristallinem Silizium, die die Oxidationskinetik des Substrats beschleunigt und die elektrischen Eigenschaften des Substrats nicht ändert und ausgewählt aus Si, Ge, Ar, Ne und He; und
b) das Wachsen durch Oxidation einer Gitteroxidschicht mit ungleichmäßiger Stärke auf der Oberfläche des Substrats aus kristallinem Silizium.

2. Verfahren nach Anspruch 1, **dadurch gekennzeichnet, dass** die chemische Gattung aus Ne und He ausgewählt wird.

3. Verfahren nach Anspruch 1, **dadurch gekennzeichnet, dass** die chemische Gattung Ar ist.

4. Verfahren nach einem der Ansprüche 1 bis 3, **dadurch gekennzeichnet, dass die** Implantationsenergie zwischen 2 und 100 keV liegt, vorzugsweise 2 bis 15 keV.

5. Verfahren nach einem der Ansprüche 1 bis 4, **dadurch gekennzeichnet, dass** die implantierte Dosis 5.10¹³ bis 5.10¹⁵ Atome.cm⁻², vorzugsweise 1.10¹⁵ bis 5.10¹⁵ Atome.cm⁻² beträgt.

6. Verfahren nach einem der Ansprüche 1 bis 5, **dadurch gekennzeichnet, dass** der Implantationsschritt ein ionischer Implantationsschritt ist.

7. Verfahren nach einem der Ansprüche 1 bis 6, **dadurch gekennzeichnet, dass** der Wachstumsschritt durch Oxidation ein Oxidationsschritt in einem Ofen, durch Plasmaoxidation, elektrochemische Oxidation oder schnelle thermische Oxidation ist.

8. Verfahren nach Anspruch 7, **dadurch gekennzeichnet, dass** der Wachstumsschritt der Gitteroxidschicht ein Oxidationsschrit in einem Ofen bei einer Temperatur von mindestens 300 °C und unter oxidierender Atmosphäre ist.
